# EUROPEAN PATENT APPLICATION

(11) **EP 3 725 922 A1**
(43) Date of publication of application: **21.10.2020**
(21) Application number: 19170254.7
(22) Date of filing: 18.04.2019
(51) Int. Cl.: C25D 17/04, C25D 17/06, H05K 3/00, B65G 49/02, C25D 21/10

(54) **SUBSTRATE HOLDER RECEPTION APPARATUS**

(71) Applicant: Atotech Deutschland GmbH, 10553 Berlin (DE)
(72) Inventor: Weinhold, Ray, 10553 Berlin (DE); Lorenz, Olaf, 10553 Berlin (DE); Hahn, Roland, 10553 Berlin (DE); Sporer, Matthias, 10553 Berlin (DE)
(74) Representative: Atotech Deutschland GmbH

(57) **Abstract**

This invention concerns a substrate holder reception apparatus (1) for holding a substrate holder (3) that is connected to a substrate (2) for treatment in an electrolyte tank (14), the substrate holder reception apparatus (1) comprising a first positioning device (11), that comprises a first connection device (71) for connecting the substrate holder (3) and a first guiding device (41) for guiding the substrate holder (3) and a drive unit (43) for moving the substrate holder (3) relative to the electrolyte tank (14), and a second positioning unit (12), that comprises a second connection device (72) for connecting the substrate holder (3) and a second guiding device (42) for guiding the substrate holder (3), wherein, in a state of connection with the first connection device (71) and the second connection device (72) with the substrate holder (3), the first guide device (41) and the second guiding device (42) are movable together with the substrate holder (3) by the drive unit (43), wherein the first guide device (41) and the second guide device (42) are movable independently from each other in a state of disconnection of the first connection device (71) and the second connection device (72) from the substrate holder (3) and the second guiding device (42) is connected to a spring mechanism (5) which, in the disconnected state, is configured to move the second guiding device (42) to the loading position. The invention further concerns an electrochemical treatment apparatus (1000). (Fig. 1)

## Description

### Field of the Invention

This invention concerns a substrate holder reception apparatus for holding a substrate holder. The substrate holder is connected to a substrate in order to treat it in an electrolyte tank. The invention further concerns an electrochemical treatment apparatus.

### Background of the Invention

The substrate can be loaded into the electrolyte tank when the substrate holder is in a loading position. When loaded, the substrate holder can hold and preferably move the substrate in the electrolyte tank during treatment. After the treatment, the substrate can be unloaded from the electrolyte tank together with the connected substrate holder.

The substrate holder reception apparatus comprises a first positioning device and a second positioning device for the substrate holder. The first and the second positioning device are preferably arranged at either side of the substrate holder in regard of a longitudinal direction of it. When moving the substrate holder, the movements of the first and the second positioning device are thus synchronized.

The first and the second positioning device each comprise a connection device for connecting the substrate holder. Further, the first positioning device comprises a first guiding device for guiding the substrate, and the second positioning device comprises a the second guiding device. Preferably, the guiding directions of the guiding devices are the same. Further, the substrate holder reception apparatus comprises a drive unit for moving the substrate holder relative to the electrolyte tank. The first guide device and the second guiding device are movable together with the substrate holder and relative to the electrolyte tank in a state of connection of the first and second connection devices with the substrate holder.

EP 3 253 907 B1 discloses a substrate holder reception apparatus in which the substrate holder is clamped between clamping arms horizontally. Both clamping arms can be moved towards each other or away from another. The arms are mechanically linked for simultaneous movement. The disadvantage of this solution is that the mechanism is mechanically complex and correspondingly expensive.

### Objective of the present Invention

In view of the prior art, it was thus an object of the present invention to provide a more cost efficient and more simple solution.

### Summary of the Invention

These objects and also further objects which are not stated explicitly but are immediately derivable or discernible from the connections discussed herein by way of introduction are achieved by a substrate holder reception apparatus having all features of claim 1 according to a first aspect of the present invention. The dependent claims concern preferred embodiment of the invention.

According to the first aspect of the invention, a substrate holder reception apparatus for holding a substrate holder is proposed that is connected to a substrate for treatment in an electrolyte tank, the substrate holder reception apparatus comprising
- a first positioning device, comprising
- a first connection device for connecting the substrate holder and
- a first guiding device for guiding the substrate holder and
- a drive unit for moving the substrate holder relative to the electrolyte tank and
- a second positioning unit, comprising
- a second connection device for connecting the substrate holder and
- a second guiding device for guiding the substrate holder,
wherein, in a state of connection with the first connection device and the second connection device with the substrate holder, the first guide device and the second guiding device are movable together with the substrate holder by the drive unit,
wherein the first guide device and the second guide device are movable independently from each other in a state of disconnection of the first connection device and the second connection device from the substrate holder and
the second guiding device is connected to a spring mechanism which, in the disconnected state, is configured to move the second guiding device to the loading position.

In the substrate holder reception apparatus, the first guide device and the second guide device and are movable independently from each other in a state of disconnection of the first connection device and the second connection device from the substrate holder. Further, the second guiding device is connected to a spring mechanism which, in the disconnected state, is configured to move the second guiding device to the loading position.

The mechanical linkage between the first positioning device and the second positioning device is, in the state of connection, the substrate holder. An advantage of this solution is that it is cheap and easy to realize and still has full functionality.

The first and the second guiding device can be movable in a horizontal direction, in regard of gravity. The movement direction of the first and the second guiding device is preferably identical. Preferably, the first and the second guiding device are aligned to each other.

In a preferred embodiment, the spring mechanism does not exert a significant force on the substrate holder, in the loading position. If no force is present between the substrate holder and the first and first or the second positioning device, respectively, the substrate holder can easily be removed from the substrate holder reception apparatus.

In a preferred embodiment, the spring mechanism comprises two springs which act on a guiding device connector and preferably are configured to exert forces against each other in the loading position.

Preferably, the spring mechanism comprises two springs. Each of those springs acts on a guiding device connector which is connected to the second guiding device. In this way, a position of rest of the guiding device connector can be achieved in case that no further forces are exerted on it. Preferably, the springs are configured to exert forces against each other in the loading position. In this way, a preload is present in the position of rest. The force which is required to move the guiding device connector out of the rest position is higher then. This can be helpful when loading or unloading the substrate holder as it more probably stays in the loading position.

In a preferred embodiment, the spring mechanism comprises one spring which acts on a guiding connector and on a stop in the loading position.

Alternatively, it is conceivable to the use of two springs, the spring mechanism can comprises one spring. However, this spring can be made up of several separate springs. The crucial point is that they act on the guiding device connector in the same direction. A further feature of this embodiment is a stop which enables to keep the second guiding device in the loading position by action of the spring. The loading position is then the end of the travel of the second guiding device.

In a preferred embodiment, the substrate holder is configured to supply electric current to the substrate and, at the same time, to mechanically connect the first positioning device with the second positioning device, wherein the second positioning device is movable by the first positioning device, preferably against the force of the spring mechanism.

The substrate holder can be configured to supply electric current to the substrate and, at the same time, to mechanically connect the first positioning device with the second positioning device for the transmission of mechanical force in order to move the second positioning device. This multiple functionality of the substrate holder renders the construction simpler. Preferably, the second positioning device is movable by the first positioning device against the force of the spring mechanism.

In a preferred embodiment, the first guide device is configured to stay in the loading position during a process of releasing of the substrate holder from the substrate holder reception apparatus, wherein, preferably, also the second guide device is configured to stay in the loading position during a process of releasing of the substrate holder from the substrate holder reception apparatus.

It is preferred that the first guide device is configured to stay in the loading position during a process of releasing of the substrate holder from the substrate holder reception apparatus. This can, for example, used by stopping the drive device or by an appropriate mechanical locking. Preferably, also the second guide device is configured to stay in the loading position during a process of releasing of the substrate holder from the substrate holder reception apparatus. This can be achieved by the spring mechanism. In case that both the first and the second positioning device do not move, loading or unloading is simplified. A person or a robot does not have to wait until a specific releasing action is finished.

In a preferred embodiment, at least one of the first and the second connection device is connectable to the substrate holder by form-locking, wherein the form-locking is effective in a guiding direction of the first and the second guiding device.

Preferably, at least one of the first and the second connection device can be connected to the substrate holder by form-locking. It is simple and easy to load and unload the substrate holder when the connection between the substrate holder and the positioning devices is made by form-locking. If the form-locking is effective in guiding direction of the first and the second guiding device, there is the advantage that simply by loading or unloading the substrate holder, forces can be transferred from the first positioning device to the second positioning device.

In a preferred embodiment, a substrate holder reception apparatus with a first and/or second connection device is proposed, wherein, in the loading position, this first and/or the second connection device is not form-locking in vertical or semi-vertical direction such that the substrate holder is liftable from this first and/or second connection device.

The case that form-locking is provided between the substrate holder and the first and the second positioning device, it is preferred that in the loading position, however, the first and/or the second connection device is not form-locking in vertical or semi-vertical direction, Then the substrate holder is can be lifted from the first and/or connection device. A semi-vertical direction is the direction which as a vertical component, but also a horizontal component, wherein the vertical component is greater.

In a preferred embodiment, the first connection device and/or the second connection device has a mechanical linkage to the first guiding device or the second guiding device, respectively, wherein the mechanical linkage, at the first connection device and/or the second connection device, extends from the first connection device and/or the second connection device downward and/or in horizontal direction and/or not in vertical direction and/or not in semi-vertical direction, wherein, preferably, the first connection device and/or the second connection device has the form of a protrusion or a ridge or has at least approximately and at least partially a cylindrical or rounded or polygonal cross-section and is supported from a side in horizontal direction.

The first connection device and/or the second connection device can have a mechanical linkage to the first guiding device or the second guiding device, respectively. This mechanical linkage at the first connection device and/or the second connection device can extend from the first connection device and/or the second connection device downward and/or in horizontal direction and/or not in vertical direction and/or not in semi-vertical direction. Then, form-locking takes place in horizontal direction and does not take place in a vertical or semi-vertical direction. Preferably, the first connection device and/or the second connection device has the form of a protrusion or a ridge. These connection devices are linked to the first and/or second positioning device in downward direction. The connection device can also have, at least approximately and at least at a section, a cylindrical or rounded or polygonal cross-section. The connected device can then, for example, health reform of a bolt with a horizontal orientation of its longitudinal axis. It can be supported in horizontal direction from one side or from two opposite sides.

The substrate holder can comprise a connection section which is open at the underside. Preferably, two such connection sections can be arranged at opposite ends of the substrate holder.

In a preferred embodiment, the at least one of the first and the second connection device is connectable to the substrate holder by force closure, wherein the force closure is effective in guiding direction of the first and the second guiding device.

It is also conceivable that the at least one of the first and the second connection device can be connectable to the substrate holder by force closure. Force closure is then effective in guiding direction of the first and the second guiding device in order to be able to transfer forces from the first positioning device to the second positioning device.

In a preferred embodiment, the substrate holder reception apparatus comprises a clamping mechanism which is configured to clamp the substrate holder between a clamping shoe and a counter bearing and which is connected to at least one of the first and/or second positioning device.

The substrate holder reception apparatus can comprises a clamping mechanism which is configured to clamp the substrate holder between a clamping shoe and a counter bearing. The clamping mechanism is preferably connected to at least one of the first and/or second positioning device. Then, it can be moved together with the corresponding positioning device. The counter bearing can for example be a connection device of the corresponding positioning device.

In a preferred embodiment, the clamping mechanism can comprise a clamping shoe which is, additionally to clamping the substrate holder, configured to transmit electric current to the substrate holder. By such clamping, the mechanical connection between the substrate holder and the respective positioning device can be improved. An electrical connection can be established or improved.

In a further aspect of the invention, an electrochemical treatment apparatus is proposed which comprises a substrate holder reception apparatus according to one of the preceding claims. Preferably, such an electrochemical treatment apparatus comprises a substrate holder as mentioned above.

### Brief Description of the figures

Objects, features, and advantages of the present invention will also be-come apparent upon reading the following description in conjunction with the figures, in which:
Figure 1 shows in a schematical cross-section of a front view of a substrate holder reception apparatus in an embodiment of the invention.
Figure 2 shows in a schematical cross-section a second positioning device of the substrate holder reception apparatus of Figure 1.
Figure 3 shows in a schematical cross-section a first positioning device of the substrate holder reception apparatus of Figure 1.

### Detailed Description of the Invention

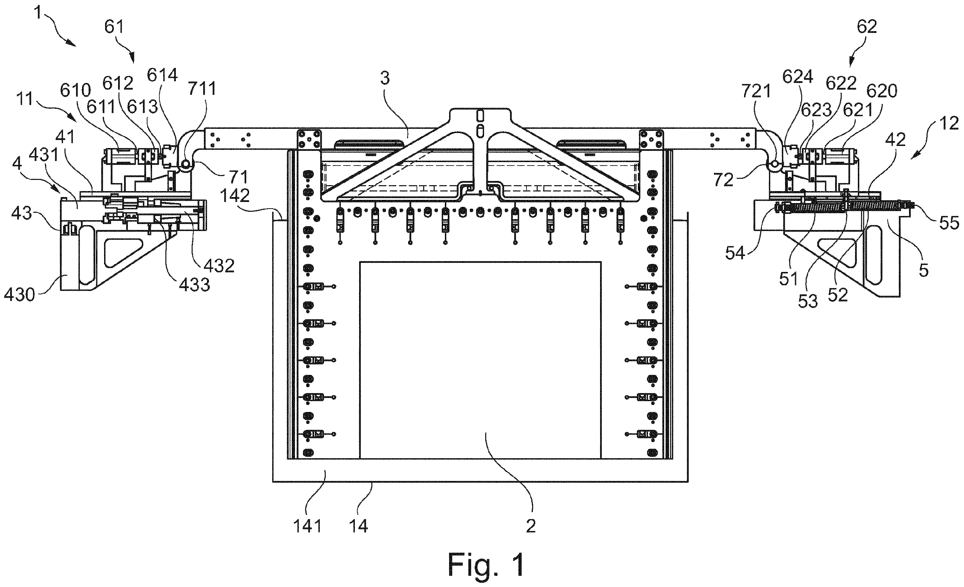

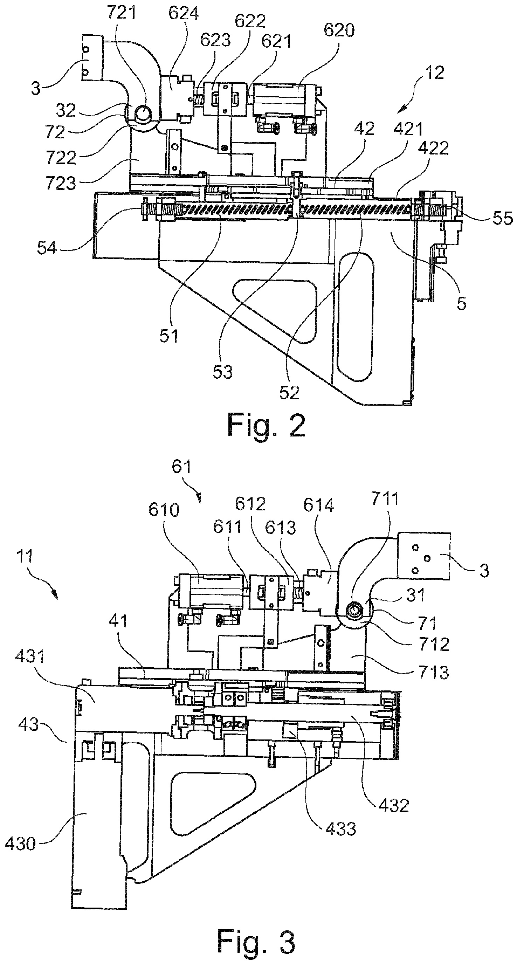

Figure 1 schematically shows in a front view an embodiment of a substrate holder reception apparatus 1 in which the direction of gravity is downward. The substrate holder and reception apparatus 1 comprises a first positioning device 11 and a second positioning device 12. Figure 2 shows a magnified view of a the second positioning device 12 of the cross-section that is shown in Figure 1, and Figure 3 shows a magnified view of a the first positioning device 11 of the cross-section that is shown in Figure 1.

Between the first positioning device 11 and the second positioning device 12, a substrate 3 is arranged. The substrate holder 3 is partially arranged in an electrolyte tank 14 which is filled with an electrolyte 141 up to an electrolyte level 142. A substrate 2 which is depicted very schematically is carried by the substrate holder 3. The substrate 2 is submerged in the electrolyte 141 completely. The substrate 2 can be moved inside the electrolyte tank 14 together with the substrate holder 3.

The substrate holder 3 can be positioned and moved in the horizontal direction by the first and the second positioning devices 11, 12. For this purpose, the first and the second positioning device 11, 12 comprise a first and a second guiding device 41, 42, respectively. The first and the second guiding device 41, 42 each have a fixed part 411, 421 and a movable part 412, 422. The first and the second positioning device 11, 12 are movable in the same direction. Preferably, this is the horizontal direction. In order to move the substrate holder 3, the first positioning device 11 comprises the drive unit 43. The drive unit 43 comprises an electric motor 430 which is connected to an angular gear 431. The angular gear 431 this connected to a spindle 472 on which a drive nut 433 is arranged. The drive nut 433 is linked to the movable part 411 of the first guiding device 41.

The second positioning device 12 is connected to the substrate holder 3 by a second connection device 72. The second connection device 72 comprises a bolt 721 which has a circular cross-section and extends in a direction perpendicular to the drawing plane of Figures which is the same in all Figures. The bolt 721 is connected to a bolt holder 723. The bolt holder 723 is mechanically linked to the movable part 722 of the second guiding device 72. The bolt 721 can be supported at both of its longitudinal ends. A second bolt holder to which the bolt 721 is also connected can be present which is located out of the drawing plane towards the viewer and is thus not visible. The connection device 72 comprises and introducer disc 722 that facilitates connecting the substrate holder 3 to the connected device 72. A second introducer disc can be present which is located at the end of the bolt 721 which is out of the drawing plane towards the viewer and is thus not visible. A first connection device 71 with the same construction is present at the first positioning device 11. The first connection device 71 comprises a bolt 711, a visible introducer disc 712 and potentially also a second introducer disc at the other end of the bolt 711 which is not visible.

The substrate holder 3 comprises a first connection section 31 edit and which is directed to the first positioning unit 11 and a second connection section 32 at its end which is directed towards the second positioning unit 12, when the substrate holder 3 is loaded. The first and the second connection sections 31 and 32 are bent in direction of gravity, as seen in a loaded state of the substrate holder 3. The lower ends of the first and the second collection section are bifurcated, wherein the bifurcations are arranged at the underside of the ends of the substrate holder 3.

The substrate holder reception apparatus comprises a first and a second clamping mechanism 61 and 62 which are arranged at the first positioning unit 11 and the second positioning unit 12, respectively. The first and the second clamping mechanisms and 61 and 62 are mechanically linked to the movable parts 411 and 421 of the guiding devices 41 and 42, respectively. The first clamping mechanism 61 comprises a first clamping motor 610, and the second clamping mechanism 62 comprises a second clamping motor 620. The clamping motors 610 and 620 have a first and a second clamping motor shaft 611, 621, respectively. The first and the second clamping motor shafts 611, 621 are connected to a first and a second clutch 612, 622, respectively, which connect the first and the second clamping motor shaft 611, 621 to a first and a second clamping spindle 613, 623, respectively. The first and the second clamping spindle 613, 623 each are connected with a clamping shoe 614, 624 which are movable towards the substrate holder 3 and away from it, by the first and the second clamping spindle 613, 623, respectively. The substrate holder 3 has a surface towards each of the clamping shoes 614, 624 which as a shape that corresponds to the shape of the clamping shoes 614, 624 which is directed towards the substrate holder 3, respectively, such that a sufficient contact area is achieved.

In a clamped state, the clamping mechanisms 61 and 62 fix the form-locking connections between the substrate holder 3 and the first and the second connection device 71 and 72 by force closure, respectively. A further purpose of the clamping mechanisms 61 and 62 is to provide an electrical connection between the substrate holder 3 and the clamping shoes 614 and 624, respectively. The clamping shoes 614 and 624 can be electrically connected to a line for current supply to the substrate 2 via the substrate holder 3. The connecting devices 71 and 72 are preferably electrically isolating in order to isolate the substrate holder 3 from the first and the second positioning device 11 and 12. The bolts 711, 721 and the introducer discs 712, 722 can be made of an electrically isolating material.

### LIST OF REFERENCE SIGNS

- 1: Substrate holder reception apparatus
- 11: First positioning device
- 12: Second positioning device
- 14: Electrolyte tank
- 141: Electrolyte
- 142: Electrolyte level
- 2: Substrate
- 3: Substrate holder
- 31: First connection section of the substrate holder
- 32: Second connection section of the substrate holder
- 4: Drive assembly
- 41: First guiding device
- 411: Fixed part of the first guiding device
- 412: Movable part of the first guiding device
- 42: Second guiding device
- 421: Fixed part of the second guiding device
- 422: Movable part of the second guiding device
- 43: Drive unit
- 430: Electric motor
- 431: Angular gearbox
- 432: Spindle
- 433: Drive nut
- 5: Spring mechanism
- 51: First spring
- 52: Second spring
- 53: Guiding device connector
- 54: First adjustment device
- 55: Second adjustment device
- 61: First clamping mechanism
- 610: First clamping motor
- 611: First clamping motor shaft
- 612: First clutch unit
- 613: First clamping spindle
- 614: First clamping shoe
- 62: Second clamping mechanism
- 620: Second clamping motor
- 621: Second clamping motor shaft
- 622: Second clutch unit
- 623: Second clamping spindle
- 624: Second clamping shoe
- 71: First connection device of the first positioning device
- 711: Bolt of the first connection device
- 712: Introducer disc of the first connection device
- 713: Bolt holder
- 72: First connection device of the first positioning device
- 721: Bolt of the first connection device
- 722: Introducer disc of the first connection device
- 723: Bolt holder
- 1000: Electrochemical treatment apparatus

## Claims

1. Substrate holder reception apparatus (1) for holding a substrate holder (3) that is connected to a substrate (2) for treatment in an electrolyte tank (14), the substrate holder reception apparatus (1) comprising
- a first positioning device (11), comprising
- a first connection device (71) for connecting the substrate holder (3) and
- a first guiding device (41) for guiding the substrate holder (3) and
- a drive unit (43) for moving the substrate holder (3) relative to the electrolyte tank (14) and
- a second positioning unit (12), comprising
- a second connection device (72) for connecting the substrate holder (3) and
- a second guiding device (42) for guiding the substrate holder (3),
wherein, in a state of connection with the first connection device (71) and the second connection device (72) with the substrate holder (3), the first guide device (41) and the second guiding device (42) are movable together with the substrate holder (3) by the drive unit (43),
**characterized in that** the first guide device (41) and the second guide device (42) are movable independently from each other in a state of disconnection of the first connection device (71) and the second connection device (72) from the substrate holder (3) and
the second guiding device (42) is connected to a spring mechanism (5) which, in the disconnected state, is configured to move the second guiding device (42) to the loading position.

2. Substrate holder reception apparatus (1) according to claim 1, **characterized in that** the spring mechanism (5) does not exert a significant force on the substrate holder, in the loading position.

3. Substrate holder reception apparatus (1) according to claim 1 or 2, **characterized in that** the spring mechanism comprises two springs (51, 52) which act on a guiding device connector (53) and preferably are configured to exert forces against each other in the loading position.

4. Substrate holder reception apparatus (1) according to claim 1 or 2, **characterized in that** the spring mechanism comprises one spring (51, 52) which acts on a guiding connector (53) and on a stop in the loading position.

5. Substrate holder reception apparatus (1) according to one of the preceding claims, **characterized in that** the substrate holder (3) is configured to supply electric current to the substrate (2) and, at the same time, to mechanically connect the first positioning device (11) with the second positioning device (12), wherein the second positioning device (12) is movable by the first positioning device (11), preferably against the force of the spring mechanism (5).

6. Substrate holder reception apparatus (1) according one of the preceding claims, **characterized in that** the first guide device (41) is configured to stay in the loading position during a process of releasing of the substrate holder from the substrate holder reception apparatus (1), wherein, preferably, also the second guide device (42) is configured to stay in the loading position during a process of releasing of the substrate holder from the substrate holder reception apparatus (1).

7. Substrate holder reception apparatus (1) according to one of the preceding claims, **characterized in that** at least one of the first and the second connection device (71, 72) is connectable to the substrate holder (3) by form-locking, wherein the form-locking is effective in a guiding direction of the first and the second guiding device (41,42).

8. Substrate holder reception apparatus (1) with a first and/or second connection device (71, 72) according to claim 7, **characterized in that**, in the loading position, this first and/or the second connection device (71, 72) is not form-locking in vertical or semi-vertical direction such that the substrate holder (3) is liftable from this first and/or second connection device (71, 72).

9. Substrate holder reception apparatus (1) according to one of the claims 7 or 8, **characterized in that** the first connection device (71) and/or the second connection device (72) has a mechanical linkage to the first guiding device (41) or the second guiding device (42), respectively, wherein the mechanical linkage, at the first connection device (71) and/or the second connection device (72), extends from the first connection device (71) and/or the second connection device (72) downward and/or in horizontal direction and/or not in vertical direction and/or not in semi-vertical direction, wherein, preferably, the first connection device (71) and/or the second connection device (72) has the form of a protrusion or a ridge or has at least approximately and at least partially a cylindrical or rounded or polygonal cross-section and is supported from a side in horizontal direction.

10. Substrate holder reception apparatus (1) according to one of the preceding claims, **characterized in that** the at least one of the first and the second connection device (71, 72) is connectable to the substrate holder (3) by force closure, wherein the force closure is effective in guiding direction of the first and the second guiding device (41, 42).

11. Substrate holder reception apparatus (1) according to one of the preceding claims, **characterized in that** the substrate holder reception apparatus (1) comprises a clamping mechanism (61, 62) which is configured to clamp the substrate holder (3) between a clamping shoe and a counter bearing and which is connected to at least one of the first and/or second positioning device.

12. Substrate holder reception apparatus (1) according to claim 11, **characterized in that** the clamping mechanism (61, 62) comprises a clamping shoe (614, 624) which is, additionally to clamping the substrate holder (3), configured to transmit electric current to the substrate holder (3).

13. Electrochemical treatment apparatus (1000), comprising a substrate holder reception apparatus (1) according to one of the preceding claims.
